# EUROPEAN PATENT APPLICATION

(11) **EP 4 199 309 A1**
(43) Date of publication of application: **21.06.2023**
(21) Application number: 23153761.4
(22) Date of filing: 30.04.2021
(51) Int. Cl.: H02J 50/60, G01R 31/28, G01R 31/42

(54) **A TESTING DEVICE FOR TESTING A WIRELESS POWER DEVICE, AND AN ASSOCIATED METHOD**

(62) Divisional of application: 21171432.4
(71) Applicant: ElectDis AB, 211 21 Malmö (SE)
(72) Inventor: Swaans, Laurens, 212 32 Malmö (SE); Andersson, Max, 211 76 Malmö (SE); Amaya, Arianna, 214 31 Malmö (SE)
(74) Representative: Ström & Gulliksson AB

(57) **Abstract**

A foreign object emulation device (100) for testing foreign object detection of a wireless power device (10; 20) having at least one wireless power coil (24; 14) is provided. The foreign object emulation device (100) comprises an emulated object (60), and a sensor unit (70) comprising at least one current sensor (72) for measuring the induced current in the emulated object (60). The measured current is indicative of a temperature increase in the emulated object (60) caused by the wireless power device (10; 20). The measured induced current is used to predict the temperature of the emulated object (60) at a predetermined time and/or to determine the relative position of the wireless power device (10; 20) and the emulated object (60) that causes the worst-case current.

## Description

### Technical Field

The present invention generally relates to the field of wireless power transfer, and more specifically to testing of wireless power transfer between a wireless power device and a testing device. Even more specifically, the present invention relates to a testing device for use in testing of wireless power devices having at least one wireless power transfer coil, where the testing device is configured to test how the wireless power transmitter and/or receiver device reacts to foreign objects. The present invention also relates to a method of testing the performance of wireless power transfer from a wireless power transmitter device having at least one wireless power transmitter coil.

### Background

Wireless power transfer is expected to become increasingly popular, for instance for wireless battery charging of mobile devices such as, for instance, mobile terminals, tablet computers, laptop computers, cameras, audio players, rechargeable toothbrushes, wireless headsets, as well as various other consumer products and appliances.

The Wireless Power Consortium has developed a wireless power transfer standard known as Qi. Other known wireless power transfer approaches include Alliance for Wireless Power, and Power Matters Alliance.

The wireless power transfer standard known as Qi by the Wireless Power Consortium will be referred to, without limitation, throughout this document as the presently preferred wireless power transfer manner applicable to the present invention. However, the invention may generally be applied also to other wireless power transfer standards or approaches, including but not limited to the ones mentioned above. Operation of devices that comply with Qi relies on magnetic induction between planar coils. Two kinds of devices are involved, namely devices that provide wireless power (referred to as base stations or wireless power transmitter devices), and devices that consume wireless power (referred to as mobile devices). Power transfer takes place from a base station to a mobile device. For this purpose, a base station contains a subsystem (a power transmitter) that comprises a primary coil, whereas a mobile device contains a subsystem (a power receiver) that comprises a secondary coil. In operation, the primary coil and the secondary coil will constitute the two halves of a coreless resonant transformer. Typically, a base station has a flat surface, on top of which a user can place one or more mobile devices so as to enjoy wireless battery charging or operational power supply for the mobile device(s) placed on the base station.

During operation, many different factors affect the quality of the wireless charging. For example, heat can be generated by magnetic induction in metal parts of the power receiver that are exposed to the magnetic field generated by the wireless power transmitter device. If the mobile device and/or the base station are exposed to excessive thermal exposure, several undesired effects may arise, for example damaging vital components in the mobile device or a reduced performance. Moreover, the charging efficiency, and thus the charging period needed, may vary depending on the orientation of the power receiver on the base station.

Another factor that affects the quality of the wireless charging is when a foreign object is placed in between the mobile device and the base station. A foreign object is in this context seen as any object that is not part of either the wireless power transmitter or wireless power receiver device and could cause unexpected losses to wireless power transfer. The energy absorbed by the foreign object is likely to result in the (unintentional) heating of the foreign object. This can lead to severe safety concerns when the temperature exceeds human safety thresholds. On top of that, excessive temperatures can cause irreparable damage to either device in close proximity of the foreign object.

In order to comply with the Wireless Power Consortium, a Base Station (Wireless Power Transmitter) or PTx, needs to have a foreign object detection functionality that interrupts the wireless power transfer and/or does not start the transfer at all when a foreign object is positioned in such a way that it could cause aforementioned undesired heating effects. Different kinds of foreign object detection methods exist, for example the Q-factor method and the loss balance method. The Q-factor method is used before the power transfer phase, whereas the loss balance method is used during the power transfer stage.

There is thus a need to test and evaluate such foreign object detection functionality in the base stations in an accurate and cost-effective way. The execution of the existing test cases requires waiting up to 10 minutes for the foreign object to heat up while the test equipment triggers the device under test, such as a power transmitter product, to enter power transfer phase and aim to receive as much power as the device under test is willing to provide. This process could lead to early shutdown of the device under test (for protection against foreign object heating) and in that case the test engineer or equipment operator has to restart the test with a slightly different setting, after letting the foreign object cool down. It could take very long time for the foreign object to cool down to a normal temperature. The prior art process is thus tedious and takes a lot of time, which in turn makes it an expensive process.

From the above it is understood that there is room for improvements in the field of testing foreign object detection functionality.

### Summary

It is an object of the invention to offer improvements in the technical field of wireless power transfer.

In a first aspect a foreign object emulation device for testing foreign object detection of a wireless power device having at least one wireless power coil is provided. The foreign object emulation device comprises an emulated object, a sensor unit comprising at least one current sensor for measuring the induced current in the emulated object, wherein the measured current is indicative of a temperature increase in the emulated object caused by the wireless power device. The measured induced current is used to predict the temperature of the emulated object at a predetermined time and/or to determine the relative position of the wireless power device and the emulated object that causes the worst-case current. The worst-case current may be the highest current.

The induced current being measured may be an eddy current.

In one embodiment, the at least one current sensor measures the root mean square (RMS) value of the current and/or the amplitude of the current.

In one embodiment, the foreign object emulation device is in operative communication with a processing means, and wherein the sensor unit is configured to transmit sensor data to the processing means. The sensor data may be transmitted to the processing means using wireless communication.

The processing means may be arranged in a host device being in communication with the foreign object emulation device.

In one embodiment, the wireless power device is a wireless power transmitter device in the form of a wireless charger. In an alternative embodiment, the wireless power device is a wireless power receiver device.

In a second aspect, a system for testing foreign object detection of a wireless power device having at least one wireless power coil is provided. The system comprising a foreign object emulation device according to the first aspect and a host device being arranged with a processing means.

In a third aspect, a method for testing foreign object detection of a wireless power device having at least one wireless power coil is provided. The method comprises providing a foreign object emulation device comprising an emulated object, and a sensor unit comprising at least one current sensor, and measuring the induced current in the emulated object. The measured current is indicative of a temperature increase in the emulated object caused by the wireless power device. The method further comprise evaluating the current data by predicting the temperature of the emulated object at a predetermined time, and/or determining the relative position of the wireless power device and the emulated object that causes the worst-case current.

In a fourth aspect, a computer readable storage medium is provided. The computer readable storage medium is encoded with instructions that, when loaded and executed by a processing means, cause the method according to the third aspect to be performed.

In a fifth aspect, a computer program product is provided. The computer program product comprises code instructions which, when loaded and executed by a processing means, cause the method according to the third aspect to be performed.

### Brief Description of the Drawings

Objects, features and advantages of embodiments of the invention will appear from the following detailed description, reference being made to the accompanying drawings.
Fig. 1 is a schematic block diagram of a wireless power transmitter device for wireless power transfer to a mobile device.
Figs. 2 are schematic block diagrams of a foreign object emulation device for use in testing of a wireless power transmitter device (Fig. 2a) and testing of a wireless power receiver device (Fig. 2b) according to one embodiment.
Figs. 3a-b are schematic views of a foreign object emulation device according to one embodiment.
Fig. 4 is a schematic view of a foreign object emulation device according to one embodiment.
Fig. 5 is a schematic view of a foreign object emulation device according to one embodiment.
Fig. 6 is a schematic view of a foreign object emulation device according to one embodiment.
Fig. 7 is a schematic view of a foreign object emulation device according to one embodiment.
Figs. 8a-b are schematic views of foreign object emulation device according to two embodiments.
Fig. 9 is a schematic block diagram of a method of testing a wireless power device using a foreign object emulation device.
Fig. 10 is a schematic block diagram of a foreign object emulation device for use in testing of a wireless power transmitter device according to one embodiment.
Fig. 11 is a schematic block diagram of a foreign object emulation device for use in testing of a wireless power transmitter device according to one embodiment.
Fig. 12 is a schematic block diagram of a foreign object emulation device for use in testing of a wireless power receiver device according to one embodiment.
Fig. 13 is a schematic block diagram of a foreign object emulation device for use in testing of a wireless power receiver device according to one embodiment.
Fig. 14 is a schematic block diagram of a foreign object emulation device comprising a probe device according to one embodiment.

### Detailed Description

Embodiments of the invention will now be described with reference to the accompanying drawings. The invention may, however, be embodied in many different forms and should not be construed as limited to the embodiments set forth herein; rather, these embodiments are provided so that this disclosure will be thorough and complete, and will fully convey the scope of the invention to those skilled in the art. The terminology used in the detailed description of the particular embodiments illustrated in the accompanying drawings is not intended to be limiting of the invention. In the drawings, like numbers refer to like elements.

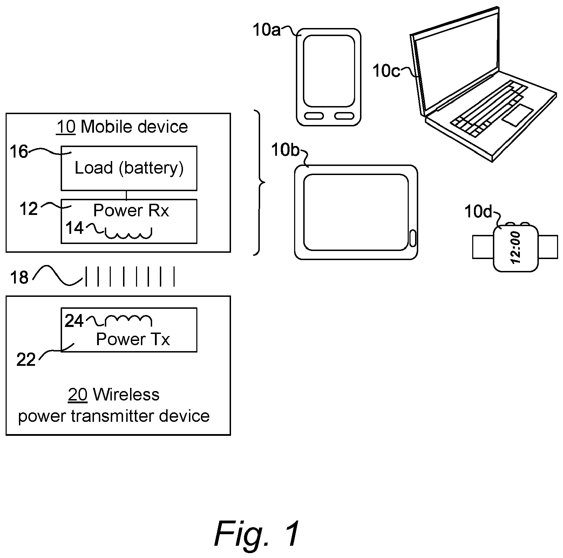

Fig. 1 illustrates a wireless power transmitter device 20 for wireless power transfer to a wireless power receiver device 10. The wireless power receiver device 10 may be a mobile device. The mobile device 10 may, for instance, be a mobile terminal (e.g. smartphone) 10a, tablet computer 10b (e.g. surfpad), laptop computer 10c, a smartwatch 10d, camera, audio player, rechargeable toothbrush, wireless headset, or another kind of consumer product or appliance.

The wireless power transfer will be described as being compliant with the Qi standard by the Wireless Power Consortium; hence, the wireless power transmitter device 20 is a base station in the Qi terminology. However, as already mentioned, the invention is generally applicable also to other wireless power transfer standards or approaches, including but not limited to the ones mentioned in the Background section.

The wireless power transmitter device 20 comprises a wireless power transmitter 22 having at least one wireless power transmitter coil 24. The transmitter device 20 may have a plurality of transmitter coils. The transmitter coils can be arranged in a spaced apart arrangement and/or in a partly overlapping manner.

The wireless power receiver device 10 comprises a wireless power receiver 12 having a wireless power receiver coil 14. In operation, the wireless power transmitter device 20 will transfer power wirelessly to the wireless power receiver device 10 by way of magnetic induction 18 via the wireless power transmitter coil 24 and wireless power receiver coil 14.

The power received by the wireless power receiver coil 14 will drive a load 16 in the wireless power receiver device 10. Typically, the load 16 may be a rechargeable battery, such as a lithium ion battery; hence, the wireless power transmitter device 20 will act as a wireless power charger for the wireless power receiver device 10. In another scenario, the load 16 may be electronic circuitry in the mobile device, wherein the wireless power transmitter device 20 will act as a wireless power supply for the wireless power receiver device 10.

As stated in the background section, a foreign object being placed in between the mobile device and the base station affects the quality of the wireless charging. This may cause unexpected losses to the wireless power transfer as well as causing unintentional heating of the foreign object. A foreign object is to be seen as any object that causes unexpected losses to wireless power transfer. This may for example be small metal objects such as coins, paper clips, pieces of foils, pharmaceutical wrappers, metal-foil-and-paper wrapper from chewing gum, cigarette packages and fast food wrappers and similar small and/or thin items. The objects may further be small electronic devices such as RFID-cards, tags or implants.

The wireless power transmitter device 20 thus preferably comprises a foreign object detection functionality. A foreign object detection functionality is a safety mechanism which automatically interrupts or constrains power delivery if there is interference caused by a foreign object. If no foreign object detection is present or is malfunctioning, small metal objects can when placed between the transmitter and the mobile device heat up to over 100°C in a matter of seconds and cause dramatic consequences. Furthermore, power receiver device 10 may also benefit from having a foreign object detection functionality. In the following, the terminology wireless power device is to be seen as covering both the wireless power transmitter device 20 and the power receiver device 10.

The inventors of the present invention have realized, after inventive and insightful reasoning, that there are problems with the approaches used in prior art systems where it is assumed that the foreign object will heat up most when both the foreign object is a s close as possible to the centre of the primary coil of the device under test, and that the device under test is providing maximum power to the test equipment.

The heating of a foreign object is based on the energy absorbed by the foreign object. The energy absorbed by the foreign object is determined by the sum of Eddy currents (also called Foucault's currents) flowing in the foreign object. The Eddy currents in the foreign object depend on the strength of the magnetic field and the electric resistance of the foreign object. The magnetic field strength is determined by the primary coil current inside the wireless power product, and the electric resistance is determined by the materials used.

Hence, the inventors of the present invention have realized that there is no guarantee that (a) the maximum power dissipation in the test equipment is causing the highest coil current on the device under test and (b) that this maximum power dissipation causes the maximum power dissipation in the foreign object.

An example of the situation (a) will now be described. Voltage on the receiver (*Vₛ*) side during a wireless power transfer can be described with the following formula *Vₛ* = *j · ω · M · Iₚ*, where *j* is an operator signifying the value is imaginary (complex numbers), *ω* is the angular frequency, M is the mutual inductance between the primary and secondary coils, and *Iₚ* is the primary coil current. From the equation, it is seen that an operating point with a high voltage and low current on the test equipment could result in a higher primary coil current than a low voltage and high current operating point.

An example of the situation (b) is achieved by regarding the fact that the foreign object, similar to how a wireless power transmitter and receiver product are coupled, also can be modeled as an inductor in series with a resistor that is coupled to the transmitter (or primary) coil.

Hence, the inventors have realized that different positions of the foreign object in the electromagnetic field can result in different power losses and/or different temperature increases. In addition to different positions, also the dimensions of the foreign object, with respect to the power coil in the wireless power device, impacts the coupling factor.

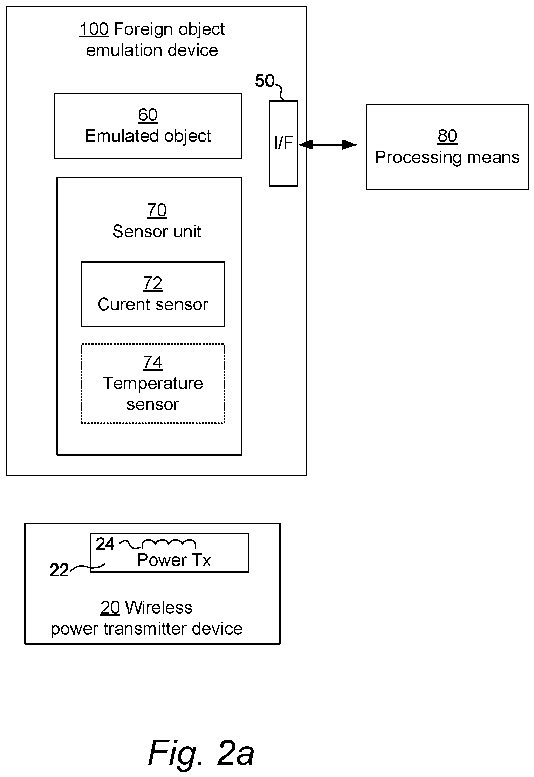

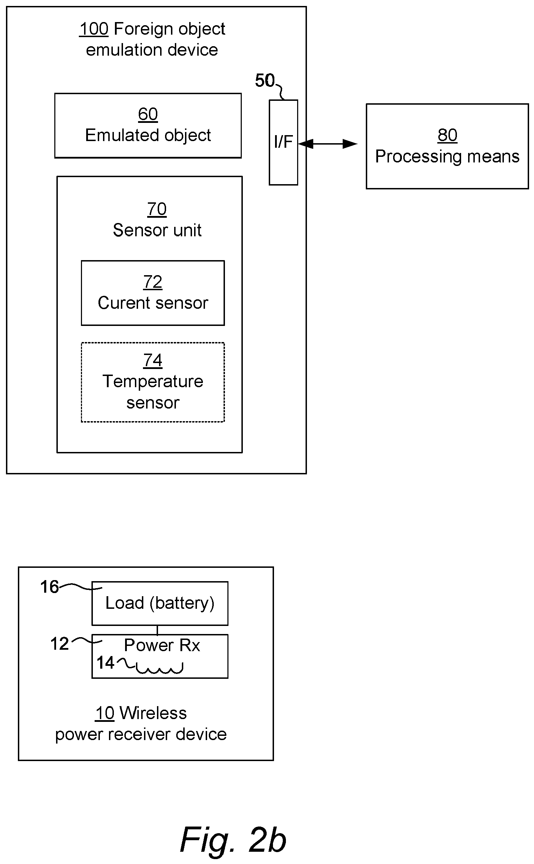

In order to test how a wireless power device, such as a wireless power transmitter device 20 or wireless power receiver device 10, reacts to a foreign object, a foreign object emulation device 100 has been provided, embodiments of which are illustrated in Figs. 2 to 8. The foreign object emulation device 100 is thus a test device configured to test the foreign object detection methods of the wireless power transmitter and/or receiver device in an improved way taking the inventive reasoning above into account.

Figs. 2a-b are schematic block diagrams that shows an embodiment of a foreign object emulation device 100 for testing a wireless power device (device under test). In Fig. 2a, the foreign object emulation device 100 is arranged to test a wireless power transmitter device 20, and in Fig. 2b, the foreign object emulation device 100 is arranged to test a wireless power receiver device 10.

In Fig. 2a, the foreign object emulation device 100 is arranged to test a wireless power transmitter device 20 having a wireless power transmitter 22 and at least one wireless power transmitter coil 24. The wireless power transmitter device 20 may be identical to the wireless power transmitter device 20 in Fig. 1.

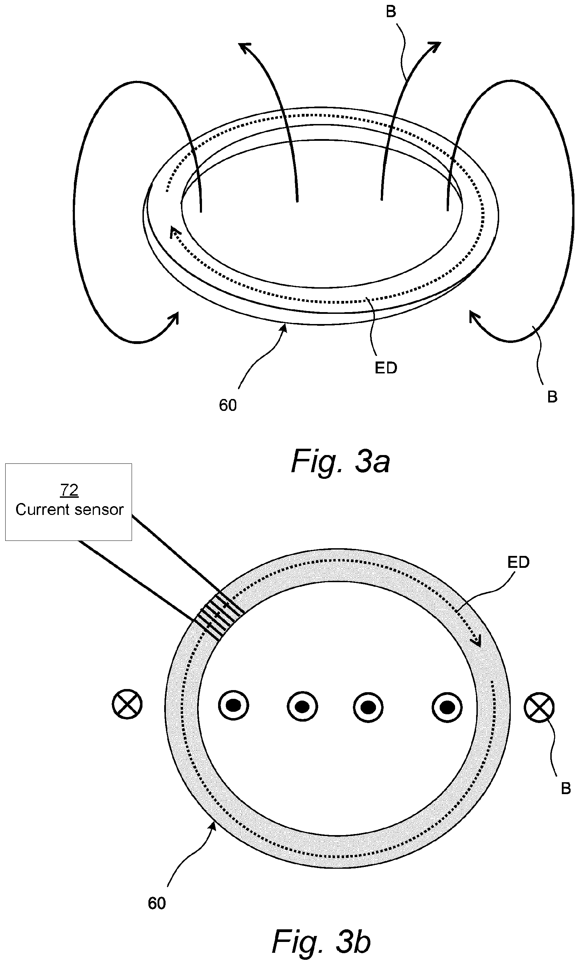

The foreign object emulation device 100 comprises an emulated object 60 that is configured to act as a foreign object. The emulated object 100 may be arranged with specific characteristics, such as size and shape and material in order to emulate a foreign object such as coins, paper clips, pieces of foils, pharmaceutical wrappers and so on. The emulated object could also be emulating a small electronic device, such as a RFID-tag, RFID-card or a smaller implant. The emulated object 60 will be discussed further with reference to Figs. 3-8.

The foreign object emulation device 100 further comprises a sensor unit 70. The sensor unit 70 comprises at least one sensor 72. The at least one sensor 72 is a current sensor 72. The current sensor is preferably arranged to measure the Eddy currents induced in the foreign object 60, as is described more in detail with reference to Figs. 3a-b.

In some embodiments, the sensor unit 70 further comprise a temperature sensor 74. The temperature sensor may also be referred to as a thermal sensor. In the exemplified embodiment shown in Fig. 2a, the sensor unit 70 comprises at least one current sensor 72 and at least one temperature sensor 74. The temperature sensor 74 is configured to measure the temperature of the emulated object 60. The temperature sensor 74 is thus preferably arranged in, on or near the emulated object 60. In one embodiment, the temperature sensor 74 is integrated into the emulated object 60. In an alternative embodiment the temperature sensor 74 is arranged in close conjunction with the emulated object 60, for example being arranged under, above or around the object 60. The temperature readings from the temperature sensor 74 may be transferred to the interface 50, which communicates the temperature information to the processing means 80.

The temperature sensor 74 may be any kind of temperature sensor, for example thermocouples, resistor temperature detectors, thermistors, infrared sensors, semiconductors and/or thermometers. In one embodiment the temperature sensor is a multi-sensor high accuracy digital temperature measurement system. It is preferred if the temperature sensor 74 is configured to digitally output the results in °C or °F with both high accuracy and resolution. For example, it is preferred if the temperature sensor 74 can output the temperature results with 0.1°C accuracy and 0.001°C resolution.

Preferably, the foreign object emulation device 100 further comprises an interface 50 for transmitting the data obtained by the foreign object emulation device 100. The interface 50 may be of any suitable type, including simple wiring, a serial interface such as USB, a wireless interface such as Bluetooth or WiFi, etc. In a preferred embodiment, the interface is Bluetooth, and more preferably Bluetooth Low Energy (BLE). The interface 50 is configured to transmit data from the foreign object emulation device 100 to a processing means 80 to which it may be in operative communication with.

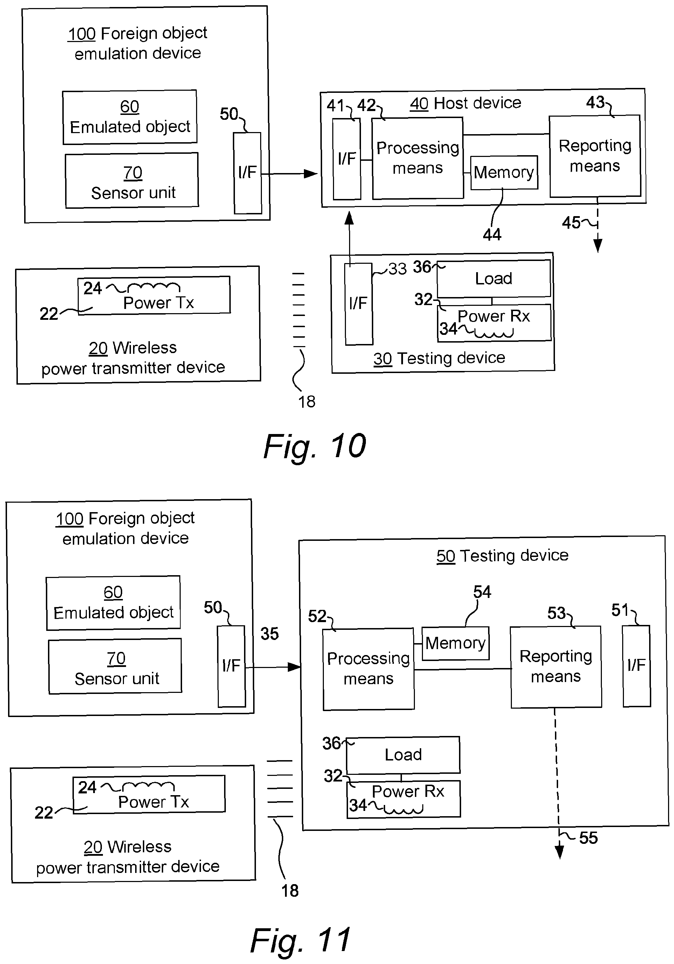

The processing means 80 may comprise a programmable device, such as a microcontroller, central processing unit (CPU), digital signal processor (DSP) or field-programmable gate array (FPGA) with appropriate software and/or firmware, and/or dedicated hardware such as an application-specific integrated circuit (ASIC). The processing means 80 can be connected to or comprises a computer readable storage medium such as a disk or memory. The memory may be implemented using any commonly known technology for computer-readable memories such as ROM, RAM, SRAM, DRAM, FLASH, DDR, SDRAM or some other memory technology. The processing means 80 may be part of the foreign object emulation device 100, be a separate unit, be part of a host device (as shown in Fig. 10) or be part of a greater testing device (as shown in Fig. 11).

As previously been mentioned, Fig. 2b illustrates a foreign object emulation device 100 arranged to test a wireless power receiver device 10. Here, the foreign object emulation device 100 is arranged to test a wireless power receiver device 10 having a wireless power receiver 12 and at least one wireless power receiver coil 14. The wireless power receiver device 10 may be identical to the wireless power receiver device 10 in Fig. 1.

Figs. 3a-b are schematic illustrations of one embodiment of a foreign object emulation device 100 shown without a wireless power device 10, 20 to be tested. Fig. 3a illustrates the foreign object emulation device 100 in isometric view, and Fig. 3b illustrates the foreign object emulation device 100 in a top view.

Figs. 3a-b show the magnetic field B generated by the device under test and the eddy currents ED induced in the emulated foreign object 60. Once the device under test 10, 20 and emulated foreign object 60 moves relative each other, the magnetic field B through a given point in the foreign object 60 varies. The variation in magnetic field B causes a circular electric field in the emulated foreign object 60. This electrical field induces a counterclockwise flow of electric current ED in the object 60, which is the Eddy current ED. Hence, Eddy currents ED are loops of electrical current induced within conductors (in this situation the foreign object acts as a conductor) by a changing magnetic field B in the conductor according to Faraday's law of induction. Eddy currents ED flow in closed loops and in planes that are perpendicular to the magnetic field B. The magnitude of the current is proportional to the strength of the magnetic field B, the area of the loop and the rate of change of flux.

As previously mentioned, the foreign object emulation device 100 comprises at least one current sensor 72. The current sensor 72 is configured to at least measure the Eddy current in the emulated foreign object 60. The current sensor 72 is preferably configured to measure the root mean square (RMS) value of the current and/or the amplitude of the current. As is known by the skilled person in this field, the RMS-value for an alternating electric current is equal to the value of the direct current that would produce the same average power dissipation in a resistive load.

In one embodiment, as shown in Figs. 3a-b and Figs. 6-7, the current sensor 72 comprises at least one sensor loop that is wound around the emulated foreign object 60. The sensor loop could be a looping wire or coil that is wound around the emulated foreign object 60 in at least one loop.

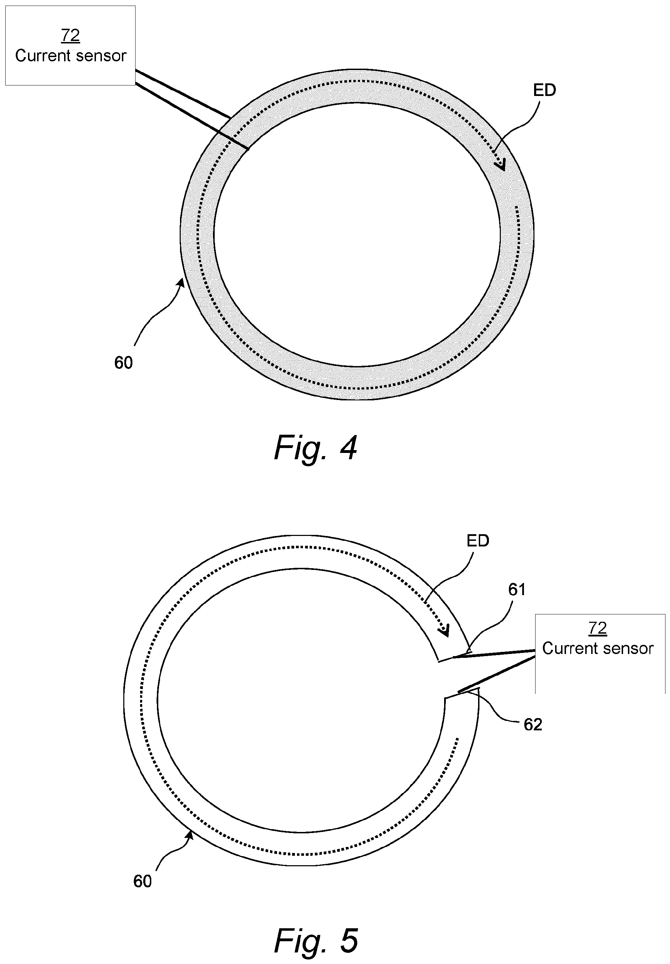

In one embodiment, as shown in Fig. 4, the at least one current sensor 74 is a Hall Effect sensor. The Hall Effect sensor may be arranged close to the foreign object 60, or be arranged as a part of the foreign object where the foreign object constitutes the current conducting wire.

The present invention does not require that all Eddy currents are measured in the object in order to be useful. Hence, the current sensor 72 does not have to be able to detect all small micro-currents that generate heat. It is sufficient that the majority of Eddy currents in the system can be measured, as these are the main contributors to temperature increase in the foreign object.

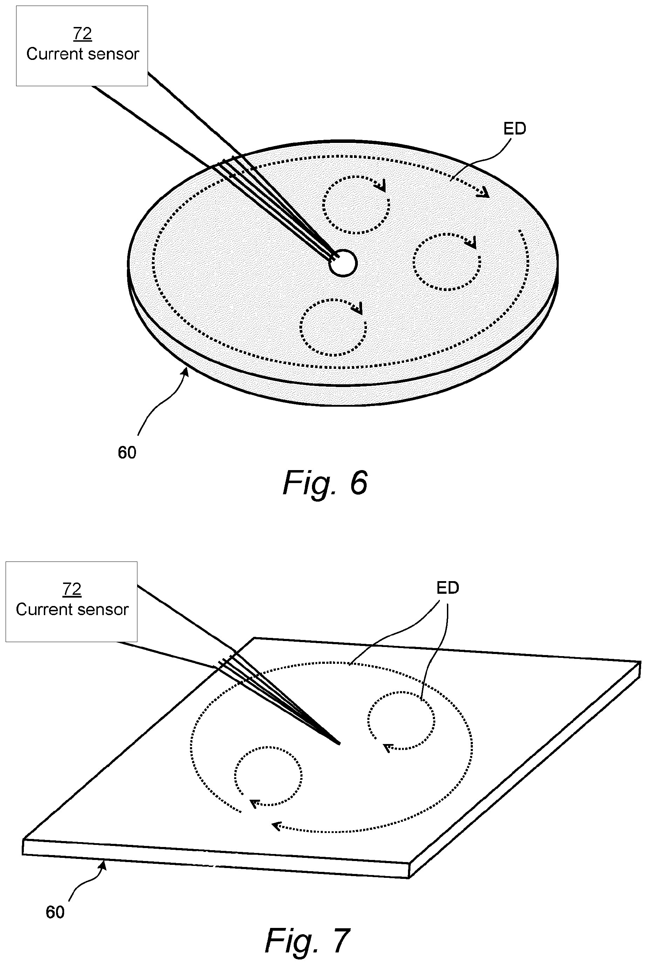

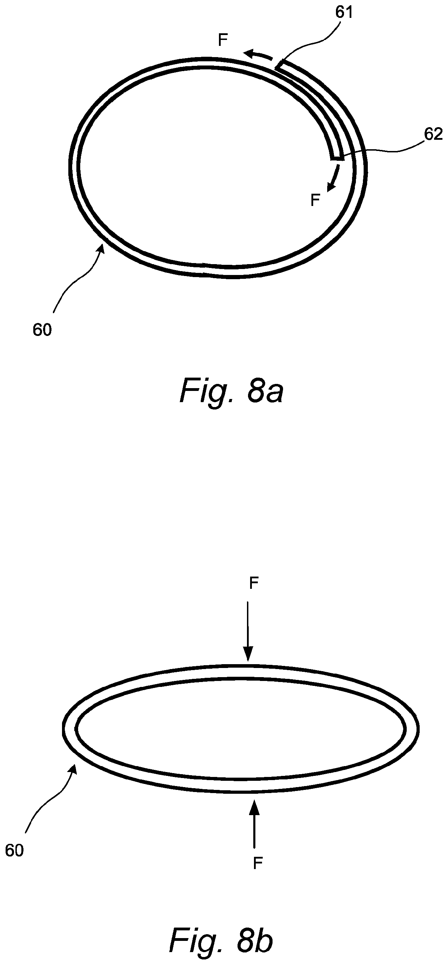

In Figs. 3-8 different embodiments of a foreign object emulation device 100 are shown. In Figs. 3-4, the emulated object 60 is in the form of a hollow circle or ellipse, in Fig. 5, the emulated object 60 is in the form of a hollow circle or ellipse having a cutout portion, in Fig. 6 the emulated object 60 is in the form of disc having a circular shape and that has a small hole in the center, and in Fig. 7 the emulated object 60 has a quadrilateral shape, such as a square or rectangle square. However, the emulated object 60 could take any form, thickness or shape suitable to simulate a real foreign object. Figs. 8a-b illustrate an emulated object that could be manipulated to change the shape and/or size. In this way, the foreign object can tune itself towards different coupling factors or induced currents.

In the embodiment illustrated in Fig. 5, the emulated object 60 is in the form of circle having a cutout portion causing an opening in the circle. Hence the emulated object 60 may be seen as a circular shape having two end portions 61, 62 arranged at a distance from one another. A close loop is created by coupling the two ends 61, 62 to the current sensor 72. Hence, the Eddy current will have to pass through the current sensor 72. This implementation allows moving the current sensor 72 away from the electromagnetic field, while still sensing the actual Eddy current.

In the embodiment illustrated in Fig. 6, the emulated object 60 is in the form of a disc having a cutout portion, or a hole, in the middle of the object. The small hole in the center can be used to wound current sensor loops around the emulated object 60. A small hole or opening will not interfere with the eddy current distribution in the emulated object, nor will it have a significant impact on the thermal characteristics of the emulated object 60.

In the embodiment illustrated in Fig. 7, the emulated object 60 has quadrilateral shape. In this example, the shape is a square, however it should be understood that it could be in the form of a rectangle, rhombus, parallelogram or the like. It should be noted that the foreign object 60 could be much larger than the area where the eddy currents flow. The eddy currents always will choose a path of low resistance and thereby tend to concentrate around the area where the magnetic field is generated. It is thus possible to adjust the size and shape of the foreign object 60 with regard to the wireless power coil in order to maximize the sensitivity of the measurement. Additionally, or alternatively, it is possible to align the wireless power coil with the size of the foreign object 60 that is to be emulated.

Figs. 8a-b illustrates embodiments of the emulated object 60 where the size and/or the shape of the emulated object 60 can be easily altered. The shape/size of the emulated object 60may be adapted using an external force F. The external form may for example be manually pressing the emulated object 60 together, or manually pull parts of the emulated object 60. In Fig. 8a, the size of the emulated object is altered by applying a force F by pulling the two end portions 61, 62 of the object in different directions. In this way, the size is decreased. In Fig. 8b, the shape of the emulated object is altered by applying a force F on one or two sides of the emulated object 60.

It is preferred if the size/shape of the emulated object 60 can be altered while measuring the induced current. Changing the size/shape of the emulated object 60 allows for new Eddy currents to be measured. By utilizing different shapes of the emulated object 60 it is thus possible to measure more, and possibly all, Eddy currents induced in the emulated object 60. The total amount of Eddy currents can be seen as the sum of the Eddy currents induced in different sizes of the emulated object 60.

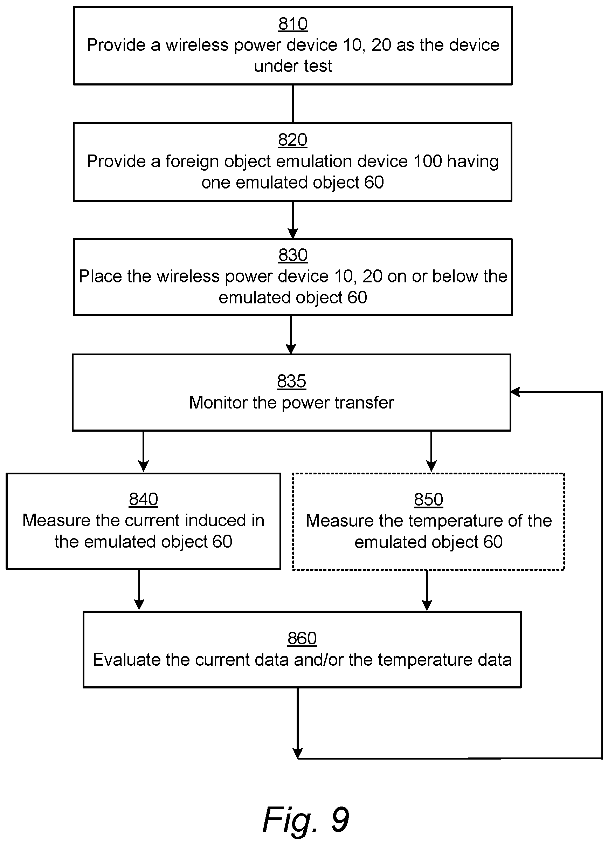

Fig. 9 illustrates an exemplified method for testing how a wireless power device 10, 20 reacts to an emulated foreign object 60. In a first step 810, a wireless power device 10, 20 to be tested is provided. The wireless power device 10 could be a wireless power transmitter device 20 or a wireless power receiver device 10.

A foreign object emulation device 100, as has been described herein, is also provided 820. The wireless power device 10, 20 is placed on a surface in conjunction with the foreign object emulation device 100. The wireless power device 10, 20 is either placed 830 above the emulated object 60 of the foreign object emulation device 100 or below it.

The method further comprises monitoring the power transfer 835, and measuring 840 the induced current in the emulated object 60. In one embodiment, the measured current is indicative of a temperature increase in the emulated object 60 caused by the wireless power device 10; 20 being tested. This method utilizes the fact that the relationship between the current and the temperature increase of a foreign object (i.e. something that can be measured and/or calibrated) is known.

The current data is transmitted to the processing means 80. The processing means 80 could be arranged in the sensor unit 70, or externally of the sensor unit 70. The processing means 80 could further be arranged external of the foreign object emulation device 100. If the processing means 80 is external to the sensor unit 70, the transmission of current data may for example be performed using the interface 50.

The processing means 80 is configured to evaluate 860 the current data. The evaluation may be based on the root mean square value of the current and/or the amplitude of the current.

The measured induced current may be used to predict the temperature of the emulated object 60 at a predetermined time. The current data is used to estimate the end temperature of the foreign object (i.e. the temperature when the foreign object has stabilized, for example 10 minutes). This measurement eliminates the need of having to wait for 10 minutes for the temperature in the foreign object to stabilize and then measure the actual temperature, as is done in prior art solutions.

Additionally, or alternatively the induced current may be used to determine the relative position of the wireless power device 10, 20 and the foreign object 60 that causes worst case current. The worst case current may be the highest current. The worst case current will represent the worst case positon that the foreign object could be arranged in. Hence, it is possible to determine the position that will likely cause the highest temperature in the foreign object if the position is maintained for a predetermined time.

Additionally, or alternatively the induced current may be used to determine the position where the induced current is low enough for the wireless power device to ignore the losses. This is an important position to detect, as the foreign object will remain undetected. It is thus good way to verify that the temperature does not exceed the safety limits. This position can be seen as the "best case scenario" from a product development point of view, as it is possible to make the foreign object detection sensitivity just good enough.

The process of step 835 to 860 is repeated by moving the wireless power device 10, 20 relative the emulated foreign object 60 and/or moving the emulated foreign object 60 relative the wireless power device 10, 20. Once the wireless power device 10, 20 has been moved relative the foreign object 60, the current data is again evaluated by the processor 80. By moving the wireless power device 10, 20 in relation to the foreign object 60 it is possibly to determine the worst case position of the foreign object 60. As previously mentioned, measuring the current data has the benefit that it is possible to find the worst case position without having going through an iterative process of finding where the object does not get detected and then see what temperature increase that leads to as is made in prior art methods.

In one embodiment, the foreign object emulation device 100 optionally measures or monitors 850 the temperature of the emulated object 60. The temperature data is then transmitted to the processing means 80, where it is evaluated 860. A rise in temperature is indicative of any electromagnetic energy absorbed in the emulated object 60The temperature measurements can be used for several purposes, as will now be described. The temperature measurements may be used to verify the temperature once a worst-case position, and/or worst-case current, has been found. It can thus be used to determine and/or verify the end temperature.

Moreover, the temperature measurement can be used to provide a starting position for the temperature. The measurement of the induced current will provide information relating to temperature increase or temperature decrease, but fails to disclose a temperature in an absolute value.

Additionally, or alternatively, the temperature measurements can be used to account for temperature dependencies of any parameter, as for example the electrical resistance.

Hence, the temperature measurements can be made initially in the process to determine the starting temperature, and/or it can be made at the end of the process to evaluate the end temperature (i.e. the highest temperature), and/or it can be made to throughout the process.

In one embodiment the processing means 80 is configured to evaluate both the current data and the temperature data. It is preferred if the current data, or current measurements, and temperature data are stored in a memory of the processing means 80.

In one embodiment, if the current data and/or the temperature data is above a predetermined threshold, the processing means 80 is configured to activate a threshold mode. The threshold mode may comprise generating and/or transmitting an alarm signal. The alarm signal may be transmitted to the wireless power device 10, 20 using the interface 50, instructing the wireless power device 10, 20 to turn off the wireless charging and/or to transmit an alarm in the form of a light, sound, etc.

The stored information about current measurement and/or the temperature of the emulated object 60 may be shown to the user by a display. The display may be part of the reporting means 43; 53 (as shown in Figs. 10-11), part of the processing means 80 or part of an external device.

The display may show information for example in the form of a text box or a table or a graphical illustration. The information may for example comprise information of the current measurements in relation to the measured or predicted temperature of the emulated object 60, information of the operating parameters of the wireless power device 10, 20 and/or information of the emulated object 60 being used. The display may be an interactive display allow the user to change the graphical interface shown, etc..

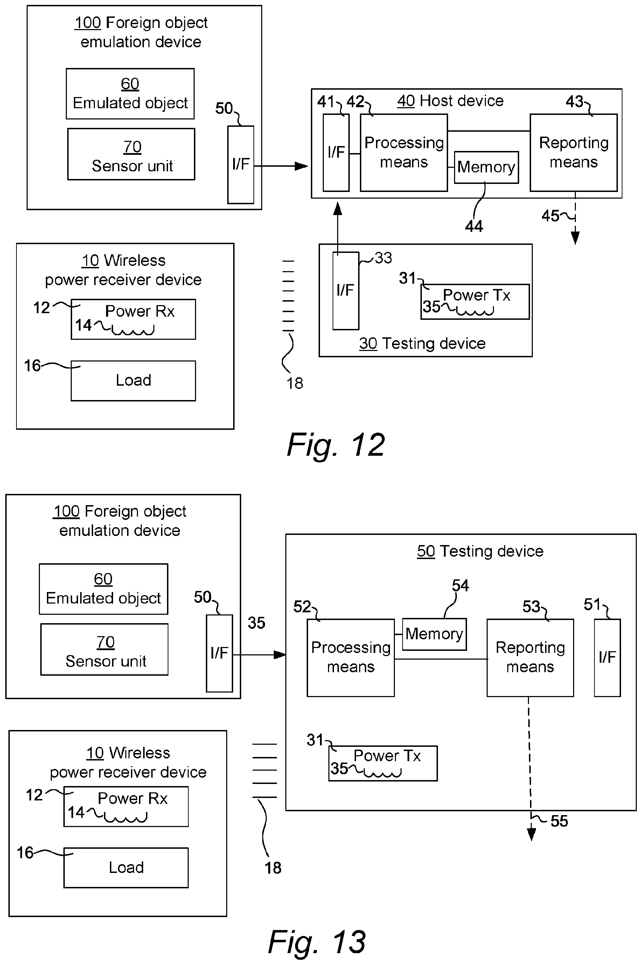

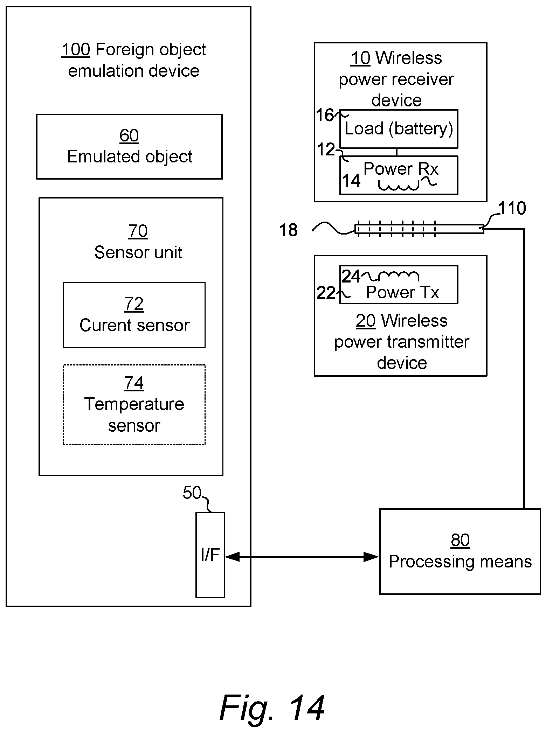

The foreign object emulation device 100 could be used in isolation or in combination with a testing device and/or a wireless probe device. However, as should be understood by a person skilled in the art, the emulation device 100 has to be exposed to an electromagnetic interface 18. Figs. 10 and 11 are schematic block diagrams that show two embodiments of a system comprising a testing receiver device 30; 50 for testing a wireless power transmitter device 20 together with a foreign object emulation device 100. Figs. 12 and 13 are schematic block diagrams that show two embodiments of a system comprising a testing transmitter device 30', 50' for testing a wireless power receiver device 10 together with a foreign object emulation device 100. Fig. 14 is a schematic block diagram of a wireless probe device 110 together with a foreign object emulation device 100.

First turning to Figs. 10 and 11, both embodiments comprise a testing device 30; 50 having a wireless power receiver 32 with at least one wireless power receiver coil 34. Moreover, the testing device 30; 50 is in in operative communication with a processing means 42; 52 (e.g. a controller) and its associated memory 44; 54, either by having the processing means 52 arranged in the testing device 50 itself (as in Fig. 11) or by being in communication with a host device 40 having the processing means 42 (as in Fig. 10).

In operation during a test session, the wireless power transmitter device 20 will initiate a wireless transfer of power to the testing device 30; 50 by way of magnetic induction 18 via the wireless power transmitter coil(s) 24 and the wireless power receiver coil(s) 34 during an operational time of a test session.

A suitable load 36 may be provided to handle excess power received by the wireless power receiver coil 34 in the testing device 30; 50. For instance, a suitably dimensioned resistor may be used.

The different embodiments of the testing device 30; 50 will now be described more in detail.

Fig. 10 is a schematic block diagram which shows a testing device 30 for testing a wireless power transmitter device 20 (device under test) under the control of a host device 40. The host device 40 has an interface 41 for receiving the data obtained by the testing device 30. The interfaces 33 and 41 may be of any suitable type, including simple wiring, a serial interface such as USB, a wireless interface such as Bluetooth of WiFi, etc. The testing device 30 may for example have a cable which may be part of the interface 33 to the host device 40.

The host device 40 also has processing means 42 for processing the data received from the testing device 30. The processing means 42 may be the same as has been described with reference to Fig. 2-8. The processing means 42 is connected to or comprises a computer readable storage medium such as a disk or memory 44. The memory 44 may be configured to store data relating to the test session.

Furthermore, the host device 40 has reporting means 43 for communicating or presenting the data processing results obtained by the processing means 42. This may involve presentation of graphical information on a local user interface (e.g. display) of the host device 40, generating of visual and/or audible alarms, or communication of information to an external device, as seen at 45. Such an external device may for example be a computer or a mobile phone.

Fig. 11 is a schematic block diagram that shows a testing device 50 according to another embodiment. The testing device 50 comprises processing means 52 for processing the data received from the testing device 50. The processing means 52 may be the same as has been described with reference to Fig. 2-8. The processing means 52 is connected to or comprises a computer readable storage medium such as a disk or memory 54. The memory 54 may be configured to store data relating to the test session. Furthermore, the testing device 50 may have reporting means 53 for communicating or presenting the data processing results obtained by the processing means 52. This may involve presentation of graphical information on a local user interface (e.g. display) of the testing device 50, generating of visual and/or audible alarms, or communication of information to an external device, as seen at 55. Such an external device may for example be a computer or a mobile phone. Additionally to the reporting means 53 or alternatively, the testing device 50 may further have a communication interface 51 for receiving data from the wireless power transmitter device 20. The communication interface 51 may be of any suitable type, including simple wiring, a serial interface such as USB, a wireless interface such as Bluetooth of WiFi, etc.

The testing device 30; 50 may have any suitable shape. In one embodiment the testing device 30; 50 is arranged in a way that allows testing of the wireless power transmitter device 20 in a situation where the testing device 30; 50 emulates a mobile device. In that situation, the testing device 30; 50 may be similar in shape to a smartphone, for example having essentially the shape of a thin box with rounded edges and corners.

In one embodiment, the testing device could be an end user device, such as a consumer device, that has a testing mode. Hence, the testing device could be a mobile device such as for instance, a mobile terminal (e.g. smartphone), tablet computer (e.g. surfpad), laptop computer or another kind of consumer product or appliance being configured with a testing mode.

The testing device 30; 50 comprises a housing having a bottom side adapted for placement on a surface of the wireless power transmitter device 20. Moreover, the housing comprises a top side opposite to the bottom side. At least some parts of the housing are made of plastic or another material suitable for admitting inductive coupling between the wireless power transmitter coil(s) 24 of the wireless power transmitter device 20 and the wireless power receiver coil 34 of the testing device 30; 50.

Figs. 12 and 13 are schematic block diagrams that show two embodiments of a system comprising a testing device 30';50' for testing a wireless power receiver device 10 together with a foreign object emulation device 100, where both embodiments comprise a testing device 30'; 50' having a wireless power transmitter 31 with at least one wireless power transmitter coil 35. Similar to the embodiments of Fig. 10 and 11, the testing device 30'; 50' is in in operative communication with a processing means 42; 52 (e.g. a controller) and its associated memory 44; 54, either by having the processing means 52 arranged in the testing device 50 itself (as in Fig. 13) or by being in communication with a host device 40 having the processing means 42 (as in Fig. 12).

In operation during a test session, the testing device 30'; 50' will initiate a wireless transfer of power to the wireless power receiver device 10 by way of magnetic induction 18 via the wireless power transmitter coil(s) 35 and the wireless power receiver coil(s) 14 during an operational time of a test session.

The testing device 30'; 50' may have any suitable shape. In one embodiment the testing device 30'; 50' is arranged in a way that allows testing of the wireless power receiver device 10 in a situation where the testing device 30'; 50' emulates a wireless charger. In that situation, the testing device 30'; 50' may be similar in shape corresponding to a wireless charger.

In one embodiment, the testing device could be an end user device, such as a consumer device, that has a testing mode. Hence, the testing device could be a wireless charger or another kind of consumer product or appliance being configured with a testing mode having a wireless transmitter coil.

The novel and inventive foreign object emulation device 100 described with reference to Figs. 2-13 can be used, verified, certified, trimmed and/or calibrated using a probe device 110. Fig. 14 illustrates a system comprising a wireless probe device 110 for testing a wireless power device 10, 20 together with a foreign object emulation device 100. It is especially noted that the foreign object emulation device 100 can be used together with the probe device 110 in order to investigate, or test, two real consumer products. Hence, in one scenario, the probe device 110 is used together with the foreign object emulation device 100, one wireless power transmitter device 20 and one wireless power receiver device 10.

The probe device 110 is arranged for testing of wireless power equipment in the form of a wireless power transmitter device 20 and/or a wireless power receiver device 10. The probe device comprises at least one pickup coil. The pickup coil is adapted to be placed between a surface of a housing of the wireless power transmitter device 20 and a surface of a housing of the wireless power receiver device 10. This will will enable the pickup coil to generate electric signals by capturing electromagnetic signals exchanged between the wireless power transmitter 20 and receiver devices 10 pursuant to a wireless power transfer protocol.

The probe device 110 either comprises or is operatively connected to the analyzer device for providing the electric signals generated by the pickup coil. The analyzer device may be a part of or being the processing means 80. For this, the probe device 110 also comprises an interface for providing the electric signals generated by the pickup coil to a processing means 80.

The probe device 110 may further comprise other sensors such as temperature sensors, etc., and sensor data from these sensors may also be received by the processing unit through the interface.

The probe device 110 is preferably used in a system, and the system preferably comprises means for causing manipulation of the electromagnetic signals exchanged between the wireless power transmitter and receiver devices 20, 10. The means for causing manipulation of the electromagnetic signals may, for instance, comprise a resistive element coupled to impose a controllable load on the pickup coil of the probe device 110. Such a resistive element may be comprised in the processing means 80, be an external element or may be comprised in the probe device 110 itself. Alternatively, means for causing manipulation of the electromagnetic signals may comprises an AM modulator for causing an amplitude modulation of the electromagnetic signals exchanged between the wireless power transmitter and receiver devices 20, 10, wherein the AM modulator is controllable by the processing means. Thanks to the provision of the controllable load (for instance imposed by the resistive element), the system may be configured for controllable interception, e.g. by the resistive element, of wireless power transmitted by the wireless power transmitter device 20, so as to cause transfer of less wireless power than expected between the wireless power transmitter and receiver devices 20, 10.

As mentioned, the analyzer device 110 will be very useful in detecting if the device under test is performing as intended and provide output to that respect. The output may be provided to an internal or external storage means, a user of the device or to the host device. In short, the probe device 110 will provide signals to the analyzer device such that the analyzer can determine if the wireless power transfer is operating in a power transfer phase. If that it is the case, the analyzer device 110 will be configured to detect if one of the power transmitter device 20 or the power receiver device 10 transmits a first data packet. The analyzer device 110 will be configured to detect that a data communication configurational change is performed by the device 10, 20 transmitting the first packet. The analyzer device 110 may optionally be configured to monitor the inductive wireless power transfer interface and detect if the signaling condition is fulfilled. The analyzer device 110 may further be configured to detect if e.g. a data communication configurational change is performed without the signaling condition being fulfilled. Any detected deviations or violations of the processes described herein may result in the analyzer device 110 generating output indicating the deviation or violation.

The invention has been described above in detail with reference to embodiments thereof. However, as is readily understood by those skilled in the art, other embodiments are equally possible within the scope of the present invention, as defined by the appended claims.

## Claims

1. A foreign object emulation device (100) for testing foreign object detection of a wireless power device (10; 20) having at least one wireless power coil (24; 14), wherein the foreign object emulation device (100) comprises:
an emulated object (60), and
a sensor unit (70) comprising at least one current sensor (72) for measuring the induced current in the emulated object (60), wherein the measured current is indicative of a temperature increase in the emulated object (60) caused by the wireless power device (10; 20), **characterized in that** the measured induced current is used to predict the temperature of the emulated object (60) at a predetermined time and/or to determine the relative position of the wireless power device (10; 20) and the emulated object (60) that causes the worst-case current.

2. The foreign object emulation device (100) according to claim 1, wherein the induced current being measured is an eddy current.

3. The foreign object emulation device (100) according to claim 1 or 2,
wherein the at least one current sensor (72) measures the root mean square (RMS) value of the current and/or the amplitude of the current.

4. The foreign object emulation device (100) according to any preceding claims, wherein the sensor unit (70) further comprises at least one temperature sensor (74) configured to measure the temperature of the at least one emulated object (60).

5. The foreign object emulation device (100) according to any preceding claims, wherein the at least one current sensor (74) comprises at least one looping wire that is wound around the emulated object (60).

6. The foreign object emulation device (100) according to any of claim 1-5,
wherein the at least one current sensor (74) is a Hall Effect sensor.

7. The foreign object emulation device (100) according to any preceding claims, wherein the foreign object emulation device (100) is in operative communication with a processing means (80), and wherein the sensor unit (70) is configured to transmit sensor data to the processing means (80).

8. The foreign object emulation device (100) according to claim 7, wherein the sensor data is transmitted to the processing means (80) using wireless communication.

9. The foreign object emulation device (100) according to claim 7 or 8,
wherein the processing means (80) is arranged in a host device being in communication with the foreign object emulation device (100).

10. The foreign object emulation device according to any preceding claims,
wherein the wireless power device (10, 20) is a wireless power transmitter device (20) in the form of a wireless charger (20).

11. The foreign object emulation device according to any of claim 1-10
wherein the wireless power device (10, 20) is a wireless power receiver device (10).

12. A system for testing foreign object detection of a wireless power device (10; 20) having at least one wireless power coil (24; 14), the system comprising a foreign object emulation device (100) according to any preceding claims and a host device being arranged with a processing means (80).

13. A method for testing foreign object detection of a wireless power device (10; 20) having at least one wireless power coil (24; 14), the method comprising:
providing (810) a foreign object emulation device (100) comprising an emulated object (60), and a sensor unit (70) comprising at least one current sensor (72),
measuring (820) the induced current in the emulated object (60), wherein the measured current is indicative of a temperature increase in the emulated object (60) caused by the wireless power device (10; 20),
**characterized in that** the method further comprises:
evaluating (860) the current data by:
predicting the temperature of the emulated object (60) at a predetermined time, and/or
determining the relative position of the wireless power device (10; 20) and the emulated object (60) that causes the worst-case current.

14. A computer readable storage medium encoded with instructions that, when loaded and executed by a processing means (80), being in operative communication with a foreign object emulation device, cause the method according to claim 13 to be performed.

15. A computer program product comprising code instructions which, when loaded and executed by a processing means (80), being in operative communication with a foreign object emulation device, cause the method according to claim 13 to be performed.
